(19) Europäisches Patentamt
European Patent Office
Office européen des brevets

(11) **EP 1 869 765 B1**

(12) **EUROPÄISCHE PATENTSCHRIFT**

(45) Veröffentlichungstag und Bekanntmachung des Hinweises auf die Patenterteilung:
**28.03.2012 Patentblatt 2012/13**

(21) Anmeldenummer: **06742535.5**

(22) Anmeldetag: **05.04.2006**

(51) Int Cl.:
*H03G 9/00* (2006.01)    *H03G 7/00* (2006.01)

(86) Internationale Anmeldenummer:
**PCT/EP2006/003076**

(87) Internationale Veröffentlichungsnummer:
**WO 2006/105940 (12.10.2006 Gazette 2006/41)**

(54) **KOMPANDERSYSTEM**

COMPANDER SYSTEM

SYSTEME COMPRESSEUR-EXPANSEUR

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **05.04.2005 DE 102005015647**

(43) Veröffentlichungstag der Anmeldung:
**26.12.2007 Patentblatt 2007/52**

(73) Patentinhaber: **Sennheiser electronic GmbH & Co. KG**
**30900 Wedemark (DE)**

(72) Erfinder: **JÜRGEN, Peissig**
**30167 Hannover (DE)**

(74) Vertreter: **Gültzow, Marc**
**Eisenführ, Speiser & Partner**
**Postfach 10 60 78**
**28060 Bremen (DE)**

(56) Entgegenhaltungen:
**US-A- 4 281 295    US-A- 4 507 791**

- **PAAVO ALKU ET AL: "A NEW GLOTTAL LPC METHOD FOR VOICE CODING AND INVERSE FILTERING" PROCEEDINGS OF THE INTERNATIONAL SYMPOSIUM ON CIRCUITS AND SYSTEMS. PORTLAND, MAY 8 - 11, 1989, NEW YORK, IEEE, US, Bd. VOL. 3 SYMP. 22, 8. Mai 1989 (1989-05-08), Seiten 1831-1834, XP000131412**
- **HOLTERS M ET AL: "Compander systems with adaptive preemphasis/deemphasis using linear prediction" SIGNAL PROCESSING SYSTEMS DESIGN AND IMPLEMENTATION, 2005. IEEE WORKSHOP ON ATHENS, GREECE NOVEMBER 2 - 4, 2005, PISCATAWAY, NJ, USA,IEEE, 2. November 2005 (2005-11-02), Seiten 641-645, XP010882647 ISBN: 0-7803-9333-3**
- **LEFEBVRE R ET AL: "Spectral amplitude warping (SAW) for noise spectrum shaping in audio coding" ACOUSTICS, SPEECH, AND SIGNAL PROCESSING, 1997. ICASSP-97., 1997 IEEE INTERNATIONAL CONFERENCE ON MUNICH, GERMANY 21-24 APRIL 1997, LOS ALAMITOS, CA, USA,IEEE COMPUT. SOC, US, Bd. 1, 21. April 1997 (1997-04-21), Seiten 335-338, XP010226203 ISBN: 0-8186-7919-0 in der Anmeldung erwähnt**

**EP 1 869 765 B1**

**Beschreibung**

Die vorliegende Erfindung betrifft eine Kompressorvorrichtung, eine Expandervorrichtung sowie ein Kompandersystem sowie ein entsprechendes Übertragungsverfahren.

Kompandersysteme sind beispielsweise aus dem Bereich der Kassettenrekorder oder der analogen FM-Radioübertragungssysteme zur Rauschunterdrückung und zur Vergrößerung des Dynamikbereiches bekannt. Eine digitale Implementation eines derartigen Systems wurde durch Peissig et al., "Digital emulation of analog companding algorithms for FM radio transmission.", In DAFX-04 Conference on Digital Audio Effects, pages 285-290, Naples, Italy, 2004., beschrieben. Dabei wurden analoge Schaltungen durch einen digitalen Signalprozessor ersetzt

Ein Kassettenrekorder bzw. eine analoge FM-Radioübertragung weist typischerweise einen Audio-Dynamikbereich von lediglich 50 - 70 dB auf. Durch diesen reduzierten Dynamikbereich kann ein hörbares Rauschen nicht vermieden werden. Zur Unterdrückung der Wahrnehmung eines derartigen Rauschens werden Audiokompressoren während der Aufzeichnung oder während der Übertragung verwendet. Der Kompressor reduziert den dynamischen Bereich der Eingangssignale, so dass sich alle Signalamplituden oberhalb des Rauschschwellenwertes befinden. Während der Wiedergabe oder während des FM-Empfangs stellt ein Expander den ursprünglichen Dynamikbereich des Signals unter Verwendung einer Dämpfung in Abhängigkeit der Signalamplitude wieder her. Somit erfolgt eine Expansion des Dynamikbereichs und gleichzeitig eine Reduktion des Rauschpegels. Ein derartiges System wird als Kompander (Kompression und Expansion) bezeichnet und stellt eine zeitvariable Verarbeitung dar zur hörbaren Veränderung des verarbeiteten Signals.

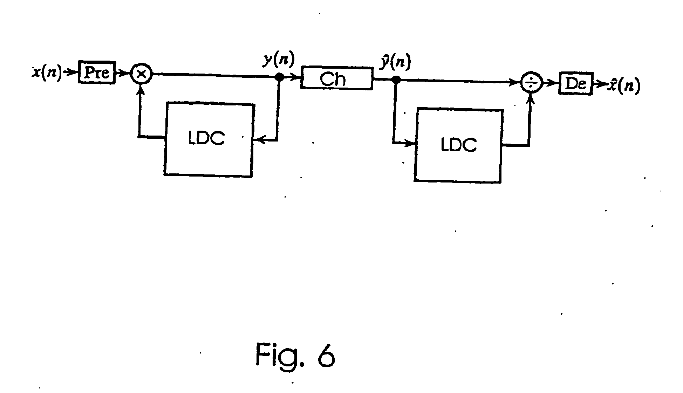

Fig. 6 zeigt ein Blockschaltbild eines herkömmlichen Kompandersystems. Das System weist eine Pre-Emphase-Einheit PRE, eine Multipliziereinheit M1, eine Pegeldetektier- und Steuereinheit LDC sowie eine Divisionseinheit D1 auf. Das komprimierte Signal wird Ober einen Kanal Ch übertragen und die Empfangs- bzw. Expanderseite weist ebenfalls eine Pegeldetektier- und Steuereinheit LDC sowie eine De-Emphase-Einheit De auf. Die Pegeldetektier- und Steuereinheit LDC dient der Ableitung eines Verstärkungsfaktors aus dem Signalpegel, so dass der Dynamikbereich des Eingangssignals in dem Kompressor reduziert wird, indem schwache Signale verstärkt werden, während starke Signale unverändert bleiben. In dem Expander auf der Empfangsseite wird der Prozess umgekehrt durchgeführt, indem die gleichen Verstärkungsfaktoren abgeleitet werden, und eine Division des Signals mittels der Divisionseinheit. D1 durch diese Verstärkungsfaktoren durchgeführt wird. Das Kanalrauschen wird für die Mehrzahl der schwachen Signale reduziert, was in eine verbesserten Audioqualität resultiert. Zusätzlich kann die Pre-Emphase-Filterung auf der Übertragungsseite implementiert werden, welche hohe Frequenzen geringfügig verstärkt, während die inverse Operation der De-Emphase-Filterung auf der Empfangsseite implementiert wird, so dass das Kanalrauschen in höheren Frequenzen gedämpft wird.

Ferner kann eine Kompression/Expansion in verschiedenen Sub-Bändern durchgeführt werden. Dies hat den Vorteil, dass Kompressionsparameter wie beispielsweise die Zeitkonstanten für die Pegeldetektion der verschiedenen Sub-Bänder individuell ausgewählt werden können, so dass eine verbesserte Abstimmung zwischen der Rauschreduktion und dem Auftauchen von Kompressionsartefakten gefunden werden kann. Ferner wird das verbleibende Rauschen am Expanderausgang nicht nur reduziert, sondern das Spektrum des Rauschens wird im Wesentlichen entsprechend dem Signal geformt, so dass viele Anteile des Rauschens unter einen hörbaren Schwellwert fallen.

"Spectral amplitude warping (SAW) for noise spectrum shaping in audio coding.", In IEEE International Conference on Acoustics, Speech, and Signal Processing, volume 1, pages 335-338, April 1997.", zeigt eine blockweise Transformation des Eingangssignals in dem Frequenzbereich, eine Anwendung eines nicht-linearen Mappings für jeden Frequenzbereich und eine Rücktransformation in den Zeitbereich unter Verwendung von "overlap-and-add". Sowohl der Transmitter als auch der Empfänger arbeiten auf diese Weise und unterscheiden sich lediglich durch die verwendete nicht-lineare Funktion. In dem Transmitter wird die k-te Frequenz X(k) gemappt durch

$$f_k(X(k)) = \frac{X(k)}{|X(k)|}|X(k)|^{\alpha(k)}, \quad 0 < \alpha(k) \le 1,$$

während im Gegensatz dazu in dem Empfänger die inverse Gleichung verwendet wird, d. h. der Exponent wird durch $1/\alpha(k)$ ersetzt.

Das sogenannte spectral amplitude warping (SAW) kann die wahrgenommene Qualität der Audiokodiersysteme verbessern, welche keine ausreichende Rauschausformung bewirken, indem Vorverarbeitungs- oder Nachverarbeitungsschritte in einem vorhandenen Kodierer implementiert werden. Es kann angenommen werden, dass dieses Verfahren ebenfalls geeignet ist für eine verrauschte analoge Kommunikationsverbindung. Der Hauptnachteil dieses Verfahrens stellt jedoch die Latenz an beiden Enden aufgrund der blockbasierten Verarbeitung dar.

Es ist somit Aufgabe der vorliegenden Erfindung, eine Kompressorvorrichtung, eine Expandervorrichtung sowie ein Kompandersystem vorzusehen, welches im Wesentlichen eine latenzfreie Veränderung des Rauschens bewirkt.

Diese Aufgabe wird durch eine Kompressorvorrichtung gemäß Anspruch 1, eine Expandervorrichtung gemäß Anspruch 3 sowie durch ein Kompandersystem gemäß Anspruch 5 gelöst und einem Verfahren gemäß Anspruch 9.

Somit wird eine Kompressorvorrichtung für ein Kompandersystem vorgesehen. Die Kompressorvorrichtung weist ein Pegel-Detektier/Steuermittel und ein Pre-Emphase-Mittel zum Durchführen einer adaptiven Pre-Emphase-Filterung auf.

Die Erfindung betrifft ebenfalls eine Expandervorrichtung für ein Kompandersystem mit einem Pegel-Detektier/Steuermittel und einem De-Emphase-Mittel zum Durchführen einer adaptiven De-Emphase-Filterung.

Weitere Ausgestaltungen der Erfindung sind Gegenstand der Unteransprüche.

Die Erfindung basiert auf dem Gedanken, adaptive Filter für die Pre-Emphase und die De-Emphase vorzusehen. In einem Kompressor wird eine dynamische Kompression in Verbindung mit einer linearen Prädiktion einer Pre-Emphase-Einheit durchgeführt. In einem Expander wird eine dynamische Expansion basierend auf einer linearen Prädiktion durchgeführt. Sowohl die Pre-Emphase-Einheit als auch die De-Emphase-Einheit kann jeweils eine Rückkopplung aufweisen.

Die Ausführungsbeispiele werden nachfolgend unter Bezugnahme auf die Zeichnungen näher erläutert

Fig. 1    zeigt ein Blockschaltbild eines Kompandersystems gemäß einem ersten Ausführungsbeispiel,
Fig. 2    zeigt Spektra eines Kompandersystems gemäß dem ersten Ausführungsbeispiel,
Fig. 3    zeigt ein Blockschaltbild eines Filters gemäß einem zweiten Ausführungsbeispiel,
Fig. 4    zeigt eine Darstellung eines Sinusimpulses,
Fig. 5    zeigt eine Darstellung einer Kompression, und
Fig. 6    zeigt ein Blockschaltbild eines Kompandersystems gemäß dem Stand der Technik.

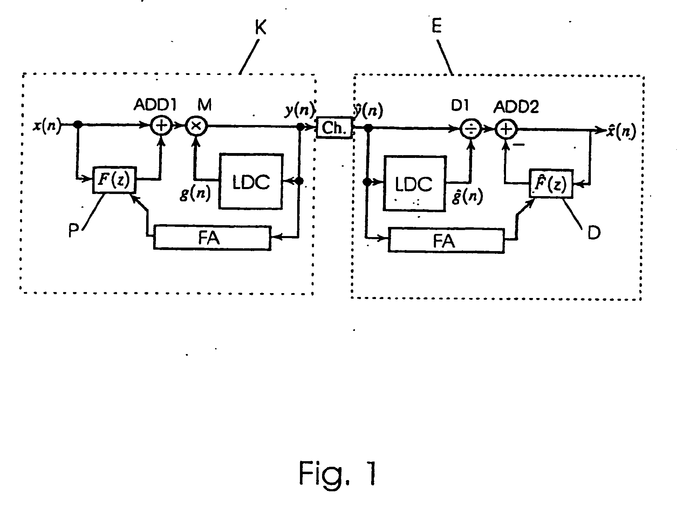

Fig. 1 zeigt ein Blockschaltbild eines Kompandersystems gemäß einem ersten Ausführungsbeispiel. Das Kompandersystem weist im Wesentlichen einen Kompressor K, einen Übertragungskanal Ch sowie einen Expander E auf. Der Kompressor K weist ein Pegel-Detektier/Steuermittel LDC, ein Filter P für die Pre-Emphase-Filterung sowie eine Filteradaptionseinheit FA auf. Der Expander E weist ebenfalls ein Pegel-Detektier/Steuermittel LDC, ein Filter D zur De-Emphase-Filterung sowie eine Filteradaptionseinheit FA auf.

Ein Eingangssignal, vorzugsweise ein Audiosignal x(n), wird zum einen der Additionseinheit ADD1 und zum anderen dem Filter P zugeführt. In dem Filter P erfolgt eine Pre-Emphase-Filterung basierend auf dem Ausgang der Filteradaptionseinheit FA. Der Ausgang des Filters P wird in der Additionseinheit ADD1 zu dem Eingangssignal x(n) hinzuaddiert. Das Ergebnis dieser Addition wird einer Multiplikationseinheit M zugeführt, wo das Ergebnis der Addition mit einem Signal g(n) multipliziert wird. Das Ergebnis der Multiplikation stellt das Ausgangssignal y(n) dar. Dieses Ausgangssignal y(n) wird sowohl der Filteradaptionseinheit FA als auch dem Pegel-Detektier/Steuermittel LDC zugeführt. Der Ausgang des Pegel-Detektier/Steuermittels LDC stellt das Signal g(n) dar.

Das Ausgangssignal y(n) wird über einen Kanal Ch übertragen. Dieser Kanal kann beispielsweise eine drahtlose Übertragungsstrecke bzw. Funkstrecke darstellen. Der Expander empfängt ein Signal $\hat{y}(n)$, welches das über den Kanal Ch übertragene Ausgangssignal y(n) darstellt. Dieses Signal wird einem Dividierer D1, einer Filteradaptionseinheit FA und einem Pegel-Detektier/Steuermittel LDC zugeführt. Der Ausgang des Pegel-Detektier/Steuermittels LDC, d. h. das Signal $\hat{g}(n)$, wird ebenfalls dem Dividierer D1 zugeführt, und somit wird das empfangene Signal $\hat{y}(n)$ durch das Signal $\hat{g}(n)$ geteilt. Das Ergebnis dieser Division wird einer zweiten Additionseinheit ADD2 zugeführt, wo ein Ausgang eines Filters G von dem Ergebnis der Division subtrahiert wird. Das Ergebnis dieser Addition stellt das Ausgangssignal $\hat{x}(n)$ dar. Dieses Signal stellt ebenfalls das Eingangssignal des Filters D dar, in welchem eine De-Emphase-Filterung basierend auf dem Ausgangssignal der Filteradaptionseinheit FA erfolgt.

Die Filter P, D sind vorzugsweise als finite impulse response FIR Filter bzw. Filter mit unbegrenztem Impulsansprechverhalten ausgestaltet, da ihre Adaption einfacher und weniger rechenintensiv erfolgen kann. Die Adaption wird vorzugsweise regelmäßig bzw. in periodischen Abständen ausgeführt. Da keinerlei Seiteninformationen übertragen werden und somit keine Blocksynchronisation möglich ist, wird die Adaption vorzugsweise nach jedem Sample durchgeführt, um eine Verzerrung aufgrund von versetzten Blöcken im Kompressor und Expander zu vermeiden. Die FIR Filter weisen vorzugsweise keinen direkten Pfad auf, um verzögerungsfreie Schleifen in dem Expander zu vermeiden.

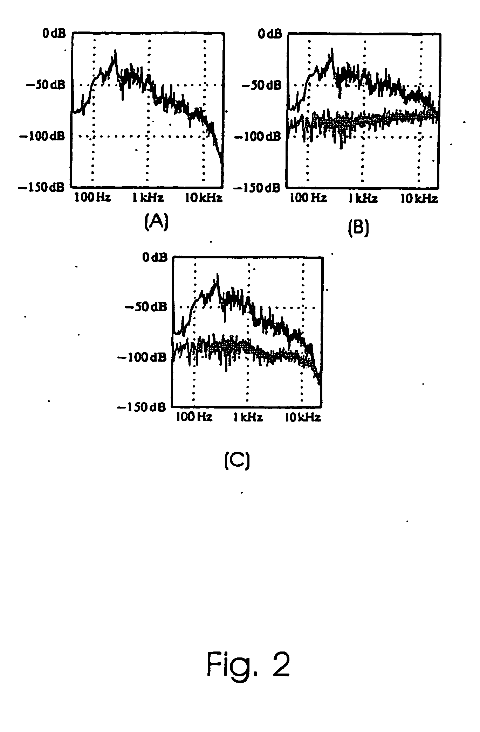

Fig. 2 zeigt drei verschiedene Spektra der Filterung gemäß dem ersten Ausführungsbeispiel. In Fig. 2A ist das ursprüngliche Eingangssignal x(n) gezeigt In Fig. 2B ist das komprimierte Signal y(n) und das Kanalrauschen gezeigt. In Fig. 2C Ist das rekonstruierte Signal $\hat{x}(n)$ und das geformte (shaped) Rauschen am Expanderausgang gezeigt.

Das Ziel der Filteradaption ist es, dass die spektrale Leistungsdichte (power spectrum) $S_{YY}(e^{jΩ})$ (mit einer nomierten Frequenz $Ω = 2\pi f/fs$) des übertragenen Signals geweißt ("whitened") wird im Vergleich mit dem ursprünglichen Signal $S_{xx}(e^{jΩ})$

$$S_{YY}(e^{j\Omega}) \approx S_{XX}{}^{a}(e^{j\Omega}),\ 0 < \alpha \leq 1, \qquad\qquad (1)$$

Die FIR Filter F(z)p sollten keinen direkten Pfad aufweisen. Der resultierende Pre-Emphase-Filter H(z) = 1+F(z) am Addierer ADD1 sollte eine minimale Phase aufweisen, um eine stabile Umkehrfunktion vorzusehen, welche durch den Expander verwendet werden kann. Der Frequenzgang eines derartigen Filters mit einer minimalen Phase mit einem Direktpfad-Koeffizienten $h_0 = 1$ erfüllt gemäß Makhoul, "Linear prediction: A tutorial review.", In Proceedings of the IEEE, volume 63, pages 561-580. April 1975., die folgende Gleichung

$$\int_{-\pi}^{\pi} \log\left|H(e^{j\Omega})\right|^2 d\Omega = 0.$$

Damit ergibt sich, dass die Filterung lediglich die Form des Spektrums verändert, den Mittelwert des logarithmischen Spektrums unverändert belässt. Folglich kann ein Breitbandkompressor zusammen mit den Filtern verwendet werden.

Somit muss ein Filter H(z) mit $h_0 = 1$ gefunden werden, welcher eine minimale Phase und ein gewünschtes Spektrum aufweist.

$$g^2\left|H(e^{j\Omega})\right|^2 = \frac{S_{YY}(e^{j\Omega})}{S_{XX}(e^{j\Omega})} \approx S_{YY}{}^{1-\frac{1}{a}}(e^{j\Omega}) \qquad\qquad (2)$$

Die Gleichung (2) wurde aus der Gleichung (1) abgeleitet, wobei g den Verstärkungsfaktor darstellt, welcher durch den Breitbandkompressor angenähert wird. Für a = 0,5 vereinfacht sich die Gleichung zu

$$g^2\left|H(e^{j\Omega})\right|^2 \approx S_{YY}{}^{-1}(e^{j\Omega}). \qquad\qquad (3)$$

Nachfolgend wir die Realisation der Adaption unter Verwendung einer linearen Prädiktion näher erläutert. Der Prädiktionsfehlerfilter, welcher sich aus einer linearen Prädiktion von y(n) ergibt, weist alle gewünschten Eigenschaften einschließlich der optimierten Approximation von Gleichung (3) auf.

Eine Lösung des Prädiktionsproblems stellen beispielsweise die Yule-Walker-Gleichungen dar:

$$R_{YY}h = -r_{YY}, \qquad\qquad (4)$$

$$R_{YY} = \begin{bmatrix} r_{yy}(0) & r_{YY}(1) & \cdots & r_{YY}(M-1) \\ r_{YY}(1) & r_{YY}(0) & \cdots & r_{YY}(M-2) \\ \vdots & \vdots & \ddots & \vdots \\ r_{YY}(M-1) & r_{YY}(M-2) & \cdots & r_{YY}(0) \end{bmatrix}$$

wobei $R_{YY}$ die Autokorrelationsmatrix darstellt,

$$r_{YY} = \begin{bmatrix} r_{YY}(1) & r_{YY}(2) & \cdots & r_{YY}(M) \end{bmatrix}^T$$

den Auto-Korrelationsvektor darstellt und

$$h = \begin{bmatrix} h_1 & h_2 & \cdots & h_M \end{bmatrix}^T$$

den Filterkoeffizientenvektor für Filter der Ordnung M darstellt Die Autokorrelation $r_{YY}(k) = E[y(n)y(n-k)]$ wird zum Zeitpunkt n aus den letzten N Samples geschätzt durch

$$r_{YY}(k;n) = \frac{1}{N-k} \sum_{i=0}^{N-k-1} y(n-i)y(n-i-k). \qquad (5)$$

Das Hauptproblem hierbei ist es jedoch, dass die Autokorrelationsmatrix $R_{YY}$ beliebig schlechte Bedingungen aufweisen kann oder selbst singulär werden kann. Dies resultiert in Sprüngen der Filterkoeffizienten jedes Mal, wenn die Gleichung (4) für einen neuen Autokorrelationsvektor $r_{YY}(k)$ erneut evaluiert wird, selbst wenn die Änderungen klein sind. Da für jedes Sample der Autokorrelationsvektor $r_{YY}(k)$ und h ermittelt wird, sind derartige Koeffizientensprünge nicht akzeptable. Um dieses Problem zu beseitigen, kann die Gleichung (4) stabilisiert werden, indem die Tatsache verwendet wird, dass die Autokorrelationsmatrix $R_{YY}$ halbdeffnit (semi-definite) ist.

$$(R_{YY} + \varepsilon I)h = -r_{YY}, \qquad \varepsilon > 0. \qquad (6)$$

Wenn ein großes Fenster N für die Berechnung der Autokorrelation verwendet wird, werden die Koeffizientensprünge ebenfalls reduziert, da dies die Differenz zwischen nachfolgenden Werten von dem Autokorrelationsvektor $r_{YY}$ (k;n) beschränkt. Dies verlangsamt jedoch die Adaption von neuen Signalcharakteristika (signal characteristics) und stellt somit eine weniger bevorzugte Lösung dar. Eine weitere Möglichkeit, die Koeffizientensprünge zu vermeiden, stellt ein Austausch der exakten Lösung des Prädiktionsproblems durch eine iterative Approximation unter Verwendung des steepest-descent-Ansatzes dar:

$$h(n+1) = h(n) - \mu((R_{YY} + \varepsilon I)h(n) + r_{YY}) \qquad (7)$$

wobei eine Iteration pro Sample durchgeführt wird. Die maximale Änderung der Filterkoeffizienten zwischen zwei aufeinander folgenden Samples kann durch den schrittweiten Parameter $\mu$ gesteuert werden. Eine Stabilisation der Autokorrelationsmatrix $R_{YY}$ wird eingehalten, um sicherzustellen, dass keine erheblichen Änderungen zwischen den Filtern im Kompressor und im Expander auftreten, selbst wenn Kanalrauschen vorhanden ist. Der Stabilisationsparameter $\in$ kann jedoch für ansonsten gleiche Einstellung kleiner gewählt werden.

Nachfolgend wird der stochastische Gradientenansatz näher beschrieben. Die beiden oben beschriebenen Ansätze sind sehr rechnerintensiv. Unglücklicherweise sind Algorithmen wie beispielsweise LMS (Least Mean Square) nicht für diesen Zweck geeignet, da sie keine Minimumphasenfilter garantieren können, wodurch teilweise unstabile Filter in dem Expander erhalten werden können.

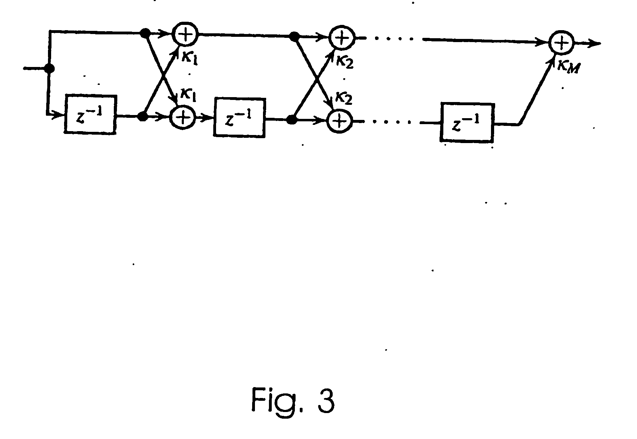

Die unstabilen Filter in dem Expander können jedoch unter Verwendung eines Lattice Filters gemäß Fig. 3 behoben werden. Der wesentliche Vorteil eines Lattice Filters stellt die Minimumphase dar, wenn die Reflektionskoeffizienten $|\kappa_i| \leq 1$ erfüllen, was leicht implementiert werden kann.

Der Gradient Adaptive Lattice GAL Algorithmus gemäß L. Griffiths, "A continuously-adaptive filter implemented as a lattice structure.", In IEEE International Conference on Acoustics, Speech, and Signal Processing, page 683-686, May 1997., stellt einen einfachen und effizienten stochastischen Gradientenalgorithmus basierend auf einem Lattice Filter dar. Während es schnell eine fast optimale Lösung erreicht, konvergiert der Algorithmus nicht, sondern die Lösung bewirkt kleine zufällige Bewegungen um das Optimum. Dies kleine zufällige Bewegungen um das Optimum. Dies stellt ein Problem für sinusförmige Signale dar, wo selbst eine geringfügige Abweichung zwischen dem Nullpunkt des Kompressorfilters und dem entsprechenden Pol des Expanderfilters in einer hörbaren Änderung des Signalpegels resultiert. Dies kann bis zu einem gewissen Grad durch Anwenden von $|\kappa_i| \leq 1\text{-}\varepsilon$ anstatt $|\kappa_i| \leq 1$ für geeignete $\in > 0$ darstellen. Die Robustheit ist jedoch geringer bei den beiden auf Autokorrelation basierenden Verfahren.

Die Breitbandkompression, welche in Verbindung mit der adaptiven Filterung verwendet wird, kann in zwei Teile eingeteilt werden, nämlich in eine Erfassung der Hüllkurve (bzw. ihres Pegels) und die Ableitung des Verstärkungsfaktors daraus.

Der hier verwendete Detektor basiert auf dem HighCom System von Telefunken, welches in J. Peissig, J.R. ter Haseborg, F. Keiler, and U. Zölzer., "Digital emulation of analog companding algorithms for FM radio transmission.", In DAFX-04 Conference on Digital Audio Effects, pages 285-290, Naples, Italy, 2004., beschrieben worden ist. Die Detektion erfolgt durch Integration (d. h. Tiefpassfilterung) des absoluten Wertes des Signals unter Verwendung von drei verschiedenen Zeitkonstanten. Die kürzeste Zeitkonstante wird für den Attack Fall verwendet, wenn der absolute Wert des augenblicklichen Samples die Hüllkurve überschreitet. In dem Release Fall wird zunächst eine sehr lange Zeitkonstante verwendet, welche die Hüllkurve nahezu konstant hält. Nach einer bestimmten Verzögerung wird eine kürzere Release Zeit verwendet, wenn kein Attack aufgetreten ist.

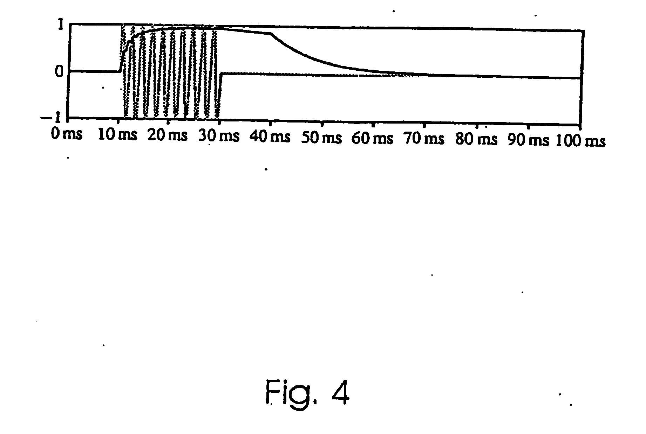

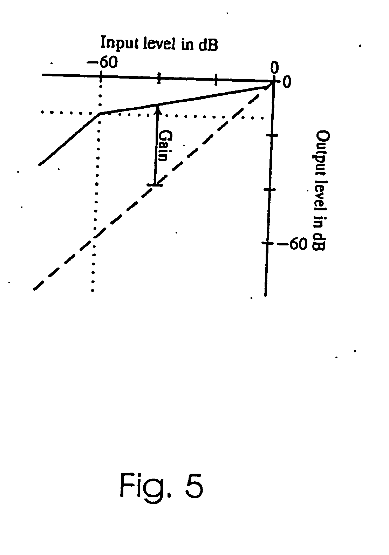

Fig. 4 zeigt eine Darstellung eines Sinusimpulses mit der resultierenden Hüllkurve. Aus dieser Hüllkurve wird die Verstärkung unter Verwendung der in Fig. 5 gezeigten Kompressionsgesetzmäßigkeit berechnet, welche die gewünschte Beziehung zwischen den Eingangs- und Ausgangssignalpegeln zeigt. Die zu verwendende Verstärkung stellt dann die Differenz zwischen dem Ausgangspegel und dem Eingangspegel dar und kann in einfacher Weise als eine Funktion des Ausgangspegels ausgedrückt werden, welche für die Feedbackstrukturen gemäß Fig. 1 benötigt wird.

Die adaptive Pre-Emphase-Filterung dämpft die Spitzen in dem Signalspektrum, während die Täler verstärkt werden, was in einer Gesamtreduzierung der Signalleistung resultiert. Somit wird eine stärkere bzw. höhere Kompression, d. h. ein höherer Kompressionsfaktor, als üblicherweise in konventionellen Kompandersystemen benötigt. Ein Kompressionsfaktor von beispielsweise 2 stellt keinen Verstärkungsfaktor g dar, welcher die Gleichung (3) erfüllt.

Typischerweise weisen analoge Übertragungskanäle, insbesondere ein Radiokanal, zusätzliches Rauschen auf. Im Vergleich zu einer tatsächlichen FM Radioverbindung stellt zusätzliches weißes Gauß'sches Rauschen ein ausreichendes Model dar, obwohl das tatsächliche Rauschen kein echtes weißes Rauschen darstellt. Die Auswirkungen des weißen zusätzlichen Rauschens auf die Autokorrelation eines Signals stellt lediglich eine Erhöhung von r(0) durch die Rauschleistung $\sigma_N^2$ dar, während alle anderen Werte unverändert bleiben. Dies weist jedoch einen ähnlichen Effekt wie die Stabilisation gemäß den Gleichungen (6) und (7) auf, so dass der Einfluss des Kanalrauschens auf den Expanderfilter für die auf Autokorrelation basierenden Verfahren vernachlässigbar ist, wenn $\sigma_N^2 \ll \varepsilon$ darstellt oder wenn die Bedingungen von $R_{YY}$ gut sind und $\sigma_N^2 \ll r_{YY}(0) + \varepsilon$ beträgt. Für sinusförmige Signale und für ein starkes Kanalrauschen wird der Expanderfilter flacher als der Kompressofilter, was in einer Dämpfung der Sinuskomponenten durch das Gesamtsystem resultiert.

Für einen GAL basierten Ansatz ist die Analyse komplizierter, da die verwendete Stabilisation keine direkte Entsprechung mit der Autokorrelation des Signals bzw. des Spektrums darstellt. Sinusförmige Signale stellen die kritischen Signale dar, da sie unter zeitveränderlichen Amplitudenänderungen für kleine Werte von ε aufgrund der Zufälligkeit des stochastischen Gradientenprozesses leiden.

Der einzige Effekt auf den Breitbandkompressor aufgrund der während der Hüllkurvendetektion durchgeführten Zeitmittelwertbildung beruht auf der Erhöhung der Signalleistung um $\sigma_N^2$, welche eine nicht ausreichende Dämpfung in dem Expander verursachen kann, solange $\sigma_N^2 \ll r_{YY}(0) = \sigma_Y^2$ darstellt. Aufgrund der durchgeführten Kompression ist $\sigma_N^2 \ll r_{YY}(0)$. Die somit bewirkte Gesamtverstärkung kompensiert die durch die Autokorrelationsverfahren bewirkte Dämpfung geringfügig.

Zusätzliches Rauschen stellt nicht den einzigen Einfluss auf den analogen Kanal dar. Die analogen Filter, beispielsweise zur Unterdrückung eines Gleichspannungsoffset, müssen mit einer nichtlinearen Phase betrachtet werden. Diese Phasenverschiebungen haben einen erheblichen Einfluss auf den Breitbandkompander, wenn die Zeitmittelwertbildung der Hüllkurvendetektion nicht ausreichend ist. Wenn die Hüllkurve dem Signal zu dicht folgt, erzeugt die resultierende Modulation des Signals eine harmonische und intermodulare Verzerrung. Ohne eine Kanaldispersion ist die Differenz der für die Kompression und Expansion verwendeten Hüllkurven klein genug, um eine Demodulation und Rekonstruktion des ursprünglichen Signals zu ermöglichen. Nach einer nichtlinearen Phasenfliterung tendiert der Expander dazu, eine zusätzliche Verzerrung einzuführen, anstatt diese zu beheben, wenn die Hüllkurve nicht ausreichend glatt ist.

Aufgrund der Charakteristik des stochastischen Gradientenprozesses ist der GAL Algorithmus sehr störanfällig im Hinblick auf eine Kanaldispersion. Die Autokorrelation hängt lediglich von dem Leistungsspektrum (power spectrum), nicht jedoch von der Phase ab. Somit sind auf einer Autokorrelation basierende Verfahren robuster, solange die Länge N des Fensters, welches zur Approximation der Autokorrelation gemäß der Gleichung (5) verwendet wird, lang genug ist, so dass Randerscheinungen vernachlässigt werden können.

Nachfolgend werden einige Simulationsergebnisse des Kompandersystems gemäß der vorliegenden Erfindung diskutiert. Dies wurde in zwei Schritten durchgeführt. Zunächst wurde die Robustheit für eine Vielzahl von Parametersätzen unter Verwendung von sinusförmigen Eingangssignalen ermittelt. Diejenigen Einstellungen, welche sich als robust erwiesen haben, d. h. weder harmonische noch intermodulare Verzerrungen oder Amplitudenveränderungen bewirkt haben, welche größer als konventionelle Kompander sind, wurden danach pseudoakustischen Messungen unterzogen.

Hierzu wurden die Objective Difference Grade ODG gemäß "ITU Radiocommunication Bureau (BR). Recommendation ITU-R BS.1387-1 - method for objective measurements of perceived audio quality." bestimmt. Hierzu wurden sechs verschiedene echte Signale bei einer Rate von $f_s$ = 44,1 kHz gesampelt, wobei der Kanalsimulationsbetrieb bei 50 dB und 30 dB Signalrauschverhältnis SNR erfolgt. Das Signalrauschverhältnis SNR wurde hinsichtlich einer sinusförmigen zu einer maximalen Amplitude gemessen. Der Allpass in dem Kanal wurde nicht verwendet, um den Unterschied zwischen Eingangs- und Ausgangssignal des Gesamtsystems zu berechnen.

| Signal | Multi-band compander SNR: 50 dB better ► | Adaptive pre-/deemphasis SNR: 50 dB better ► | Multi-band compander SNR: 30 dB better ► | Adaptive pre-/deemphasis SNR: 30 dB better ► |
|---|---|---|---|---|
| Acoustic guitar | —1.3 | —1.0 | —2.0 | —1.5 |
| E-bass | —2.0 | —1.5 | —3.3 | —2.5 |
| Male singing | —2.2 | —1.2 | —3.1 | —2.0 |
| Fem. singing | —1.1 | —1.0 | —1.4 | —1.1 |
| Male voice | —1.9 | —1.2 | —2.6 | —1.4 |
| Fem. voice | —2.0 | —1.3 | —2.8 | —1.8 |

## Tab. 1

Die Tabelle 1 zeigt die Resultate der oben beschriebenen Simulation für einen Multibandkompander mit einem adaptiven Pre-Emphase/De-Emphase Kompander. Die Einstellungen für den Multibandkompander wurden mittels Hörtests auf ein Signalrauschverhältnis SNR von 50 dB optimiert. Für den adaptiven Pre-Emphase/De-Emphase Kompander gemäß der vorliegende Erfindung wurde der steepest descent Ansatz (wie vorstehend beschrieben) für ein Filter der Ordnung M = 8, für eine Autokorrelationsfensterlänge von N = 128 und für einen Stabilisationsparameter ∈ = 0,001 verwendet. Wie aus der Tabelle 1 ersichtlich, weist der adaptive Pre-Emphase/De-Emphase Kompander gemäß der vorliegenden Erfindung eine wesentlich verbesserte wahrgenommene Audioqualität auf.

Das Kompandersystem gemäß der vorliegenden Erfindung beruht somit zum einen auf einer dynamischen Kompression und zum anderen auf einer linearen Prädiktion einer Pre-Emphase Einheit in einem Kompressor sowie in einer De-Emphase Einheit in einem Expander. Hierbei weisen die Pre-Emphase Einheit sowie die De-Emphase Einheit jeweils eine Rückkopplung auf. Derartige neuartige Kompandersysteme eignen sich nicht nur für eine Rauschreduktion, sondern auch zur Formung von Spektralrauschen. Insbesondere ist ein Filter einer Ordnung von M = 8 ausreichend, so dass Echtzeitanwendungen auf derzeit erhältlichen digitalen Signalprozessoren möglich sind. Die in der Tabelle 1 gezeigten Einstellungen benötigen ungefähr 110 Multiplikationen und Additionen pro Sample für die adaptive Filterung zusätzlich zu dem herkömmlichen Breitbandkompander.

Das oben beschriebene Kompandersystem kann beispielsweise in einem Audio-übertragungssystem eingesetzt werden. Somit kann eine Kompression eines Audioeingangssignals durch den Kompressor erfolgen, bevor das Audiosignal über einen Kanal wie beispielsweise eine Funkstrecke übertragen wird. In dem Expander kann das übertragene Audiosignal expandiert werden.

**Patentansprüche**

**1.** Kompressorvorrichtung für ein Kompandersystem, mit einem Pegel-Detektier/Steuermittel (LDC), und

einem Pre-Emphase-Filter (P) zum Durchführen einer adaptiven Pre-Emphase-Filterung eines Audiosignals (x(n)),
einer Filteradaptionseinheit (FA) zum Durchführen einer Adaption des Pre-Emphase-Mittels (P) basierend auf einer linearen Prädiktion,
einer ersten Additionseinheit (ADD1) zum Addieren des Audiosignals (x(n)) und des Ausgangssignals des Pre-Emphase-Filters (FA),
einer Multiplikationseinheit (M) zum Multiplizieren des Ausgangssignals der ersten Additionseinheit (ADD1) mit dem Ausgangssignal des PegelDetektier/Steuermittels (LDC),
wobei das Ausgangssignal der Kompressorvorrichtung (y(n)) das Ausgangssignal der Multiplikationseinheit (M), das Eingangssignal der Filteradaptionseinheit (FA) und das Eingangssignal des PegelDetektier/Steuermittels (LDC) darstellt.

2. Kompressorvorrichtung nach Anspruch 1, wobei
das Pre-Emphase-Mittel Filter mit unbegrenztem Impulsansprechverhalten aufweist.

3. Expandervorrichtung für ein Kompandersystem, mit einem Pegel-Detektier/Steuermittel (LDC), und
einem De-Emphase-Filter (D) zum Durchführen einer adaptiven De-Emphase-Filterung eines Eingangssignals,
einer Filteradaptionseinheit (FA) zum Durchführen einer Adaption des De-Emphase-Mittels (D) basierend auf einer linearen Prädiktion,
wobei das Eingangssignal mit dem Eingang des PegelDetektier/Steuermittels (LDC) und dem Eingang der Filteradaptionseinheit (FA) verbunden ist,
einer Divisionseinheit (D1) zum Dividieren des Eingangssignals der Expandervorrichtung durch das Ausgangssignal des PegelDetektier/Steuermittels (LDC),
einer zweiten Additionseinheit (ADD2) zum Subtrahieren des Ausgangssignals des De-Emphase-Filters (D) von dem Ausgangssignal der Divisionseinheit (D1).

4. Expandervorrichtung nach Anspruch 3, wobei
das De-Emphase-Mittel (D) Filter mit unbegrenztem Impulsansprechverhalten aufweist.

5. Kompandersystem, mit
einer Kompressorvorrichtung nach einem der Ansprüche 1 oder 2, und/oder einer Expandervorrichtung nach einem der Ansprüche 3 oder 4.

6. Audiosignalsendevorrichtung, mit
einer Kompressorvorrichtung gemäß einem der Ansprüche 1 oder 2.

7. Audiosignalempfangsvorrichtung, mit
einer Expandervorrichtung gemäß einem der Ansprüche 4 oder 5.

8. Audiosignalübertragungssystem, mit
einem Kompandersystem gemäß Anspruch 5.

9. Verfahren zum Übertragen von Audiosignalen, mit den Schritten:

Durchführen einer Pre-Emphase-Filterung eines Eingangssignals (x(n)),
Addieren des Eingangssignals (x(n)) und des Ergebnisses der Pre-Emphase-Filterung,
Multiplizieren des Ergebnisses der Addition mit einem Ergebnis (g(n)) einer Pegeldetektion des Ausgangssignals (y(n)) der Multiplikation, und
Adaptieren der Pre-Emphase-Filterung basierend auf einer linearen Prädiktion und dem Ausgangssignal der Multiplikation als Eingangssignal.

10. Verfahren zum Übertragen von Audiosignalen nach Anspruch 9, ferner mit den Schritten:

Empfangen eines übertragenen Signals ($\hat{y}$(n)),
Dividieren des empfangenen Eingangssignals (($\hat{y}$(n)) mit einem Ergebnis einer Pegeldetektion des empfangenen Eingangssignals ($\hat{y}$(n)),
Durchführen einer De-Emphase-Filterung eines Ausgangssignals ($\hat{x}$ (n)),
Subtrahieren des Ergebnisses der De-Emphase-Filterung des Ausgangssignals ($\hat{x}$ (n)) von dem Ergebnis der Division, und

Adaptieren der De-Emphase-Filterung basierend auf einer linearen Prädiktion und dem empfangenen Signal $(\hat{y}(n))$.

**Claims**

1. Compressor device for a compander system, having
   a level detecting/control means (LDC), and
   a pre-emphasis filter (P) for carrying out an adaptive pre-emphasis filtering of an audio signal (x(n)),
   a filter adaption unit (FA) for carrying out an adaption of the pre-emphasis means (P) based on a linear prediction,
   a first addition unit (ADD1) for adding the audio signal (x(n)) and the output signal of the pre-emphasis filter (FA),
   a multiplication unit (M) for multiplying the output signal of the first addition unit (ADD1) to the output signal of the level detecting/control means (LDC),
   wherein the output signal of the compressor device (y(n)) represents the output signal of the multiplication unit (M),
   the input signal of the filter adaption unit (FA) and the input signal of the level detecting/control means (LDC).

2. Compressor device according to claim 1, wherein
   the pre-emphasis means has filters with unlimited impulse response behaviour.

3. Expander device for a compander system, having
   a level detecting/control means (LDC), and
   a de-emphasis filter (D) for carrying out an adaptive de-emphasis filtering of an input signal,
   a filter adaption unit (FA) for carrying out an adaption of the de-emphasis means (D) based on a linear prediction,
   wherein the input signal is connected to the input of the level detecting/control means (LDC) and to the input of the filter adaption unit (FA),
   a division unit (D1) for dividing the input signal of the expander device by the output signal of the level detecting/control means (LDC),
   a second addition unit (ADD2) for subtracting the output signal of the de-emphasis filter (D) from the output signal of the division unit (D1).

4. Expander device according to claim 3, wherein
   the de-emphasis means (D) has filters with unlimited impulse response behaviour.

5. Compander system, having
   a compressor device according to either of claims 1 and 2 and/or an expander device according to either of claims 3 and 4.

6. Audio signal transmitting device, having
   a compressor device according to either of claims 1 and 2.

7. Audio signal receiving device, having
   an expander device according to either of claims 4 and 5.

8. Audio signal transmission system, having
   a compander system according to claim 5.

9. Method for transmitting audio signals, comprising the steps of:

   carrying out a pre-emphasis filtering of an input signal (x(n)),
   adding the input signal (x(n)) and the result of the pre-emphasis filtering,
   multiplying the result of the addition by a result (g(n)) of a level detection of the output signal (y(n)) of the multiplication, and
   adapting the pre-emphasis filtering based on a linear prediction and on the output signal of the multiplication as input signal.

10. Method for transmitting audio signals according to claim 9, further comprising the steps of:

   receiving a transmitted signal $(\hat{y}(n))$,

dividing the received input signal $(\hat{y}(n))$ by a result of a level detection of the received input signal $(\hat{y}(n))$,

carrying out a de-emphasis filtering of an output signal $(\hat{x}(n))$,

subtracting the result of the de-emphasis filtering of the output signal $(\hat{x}(n))$ from the result of the division, and

adapting the de-emphasis filtering based on a linear prediction and on the received signal $(\hat{y}(n))$.

**Revendications**

1. Dispositif compresseur pour un système compresseur-expanseur, comprenant
   un moyen de commande/détection de niveau (LDC) et un filtre de préaccentuation (P) servant à effectuer un filtrage de préaccentuation adaptatif d'un signal audio (x(n)),
   une unité d'adaptation de filtre (FA) servant à exécuter une adaptation du moyen de préaccentuation (P) d'après une prédiction linéaire,
   une première unité d'addition (ADD1) servant à additionner le signal audio (x(n)) et le signal de sortie du filtre de préaccentuation (FA),
   une unité de multiplication (M) servant à multiplier le signal de sortie de la première unité d'addition (ADD1) avec le signal de sortie du moyen de commande/détection de niveau (LDC),
   le signal de sortie du dispositif compresseur (y(n)) représente le signal de sortie de l'unité de multiplication (M), le signal d'entrée de l'unité d'adaptation de filtre (FA) et le signal d'entrée du moyen de commande/détection de niveau (LDC).

2. Dispositif compresseur selon la revendication 1,
   le moyen de préaccentuation comportant des filtres ayant un comportement du type à réponse impulsionnelle infinie.

3. Dispositif expanseur pour un système compresseur-expanseur, comprenant
   un moyen de commande/de détection de niveau (LDC) et un filtre de désaccentuation (D) servant à effectuer un filtrage de désaccentuation adaptatif d'un signal d'entrée,
   une unité d'adaptation de filtre (FA) servant à effectuer une adaptation du moyen de désaccentuation (D) d'après une prédiction linéaire,
   le signal d'entrée étant relié à l'entrée du moyen de commande/détection de niveau (LDC) et à l'entrée de l'unité d'adaptation de filtre (FA),
   une unité de division (D1) servant à diviser le signal d'entrée du dispositif expanseur par le signal de sortie du moyen de commande/détection de niveau (LDC),
   une deuxième unité d'addition (ADD2) servant à soustraire le signal de sortie du filtre de désaccentuation (D) du signal de sortie de l'unité de division (D1).

4. Dispositif expanseur selon la revendication 3, le moyen de désaccentuation (D) comportant des filtres ayant un comportant du type à réponse impulsionnelle infinie.

5. Système compresseur-expanseur, comprenant
   un dispositif compresseur selon l'une quelconque des revendications 1 et 2, et/ou un dispositif expanseur selon l'une quelconque des revendications 3 et 4.

6. Dispositif d'émission de signal audio, comprenant un dispositif compresseur selon l'une quelconque des revendications 1 et 2.

7. Dispositif de réception de signal audio, comprenant un dispositif expanseur selon l'une quelconque des revendications 4 et 5.

8. Système de transmission de signal audio comprenant
   un système compresseur-expanseur selon la revendication 5.

9. Procédé de transmission de signaux audio, comprenant les étapes consistant à :

   exécuter un filtrage de préaccentuation d'un signal d'entrée (x(n)),
   additionner le signal d'entrée (x(n)) et le résultat du filtrage de préaccentuation,
   multiplier le résultat de l'addition par le résultat (g(n)) d'une détection de niveau du signal de sortie (y(n)) de la multiplication, et

adapter le filtrage de préaccentuation d'après une prédiction linéaire et le signal de sortie de la multiplication en tant que signal d'entrée.

**10.** Procédé de transmission de signaux audio selon la revendication 9, comprenant en outre les étapes consistant à :

recevoir un signal transmis ($\hat{y}(n)$),
diviser le signal d'entrée reçu (($\hat{y}(n)$) par un résultat d'une détection de niveau du signal d'entrée reçu ($\hat{y}(n)$),
exécuter un filtrage de désaccentuation d'un signal de sortie ($\hat{x}(n)$),
soustraire le résultat du filtrage de désaccentuation du signal de sortie ($\hat{x}(n)$) du résultat de la division, et
adapter le filtrage de désaccentuation d'après une prédiction linéaire et le signal reçu ($\hat{y}(n)$).

Fig. 1

Fig. 2

Fig. 3

Fig. 4

Fig. 5

Fig. 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **PEISSIG et al.** Digital emulation of analog companding algorithms for FM radio transmission. *DAFX-04 Conference on Digital Audio Effects,* 2004, 285-290
- Spectral amplitude warping (SAW) for noise spectrum shaping in audio coding. *IEEE International Conference on Acoustics, Speech, and Signal Processing,* April 1997, vol. 1, 335-338
- **MAKHOUL.** Linear prediction: A tutorial review. *Proceedings of the IEEE,* April 1975, vol. 63, 561-580

- **L. GRIFFITHS.** A continuously-adaptive filter implemented as a lattice structure. *IEEE International Conference on Acoustics, Speech, and Signal Processing,* Mai 1997, 683-686
- **J. PEISSIG ; J.R. TER HASEBORG ; F. KEILER ; U. ZÖLZER.** Digital emulation of analog companding algorithms for FM radio transmission. *DAFX-04 Conference on Digital Audio Effects,* 2004, 285-290